# EUROPEAN PATENT APPLICATION

(11) **EP 4 074 488 A1**
(43) Date of publication of application: **19.10.2022**
(21) Application number: 22725152.7
(22) Date of filing: 19.01.2022
(51) Int. Cl.: B29C 45/14, H01L 23/29, H01L 23/31, C08K 5/21, C08K 5/3445, C08L 61/00, C08L 101/00, C08K 3/013, C08K 3/36

(54) **SEALING RESIN COMPOSITION FOR INJECTION MOLDING**

(30) Priority: 17.02.2021 JP 2021023120
(71) Applicant: Sumitomo Bakelite Co., Ltd., Shinagawa-ku Tokyo 140-0002 (JP)
(72) Inventor: MOCHIZUKI, Shunsuke, Shinagawa-ku Tokyo 140-0002 (JP)
(74) Representative: Müller-Boré & Partner Patentanwälte PartG mbB
(86) International application number: PCT/JP2022/001779
(87) International publication number: WO 2022/176486

(57) **Abstract**

An encapsulating resin composition for injection molding of the present invention includes a thermosetting resin, a curing agent, an inorganic filler, and an imidazole catalyst, in which in a DSC curve obtained in a case where a temperature is raised from 30°C to 330°C by using a differential scanning calorimeter under a condition of a temperature rise rate of 10°C/min, a peak temperature of a maximum exothermic peak is equal to or higher than 155°C and lower than 175°C, and width in a half value of the maximum exothermic peak, which is obtained by adopting a straight baseline that connects a point of a minimum heat flow before the maximum exothermic peak and a point of a minimum heat flow after the maximum exothermic peak, is equal to or lower than 32°C.

## Description

### TECHNICAL FIELD

The present invention relates to an encapsulating resin composition for injection molding.

### BACKGROUND ART

Various studies have been conducted for the purpose of stabilizing heat treatment in an injection molding extruder. Examples of this kind of technique include the technique described in Patent Document 1. According to the same document, it is described that excellent thermal stability in a molding machine cylinder is achieved by blending one or more kinds of predetermined dimethylurea-based curing accelerators.

It is described in Patent Document 2 that an epoxy resin composition contains a predetermined epoxy resin, a phenol-based curing agent, a curing catalyst, and an inorganic filler, and an exothermic peak top of the epoxy resin composition is equal to or higher than 150°C in a case where the epoxy resin composition is subjected to differential scanning calorimetry under a condition of a temperature rise rate of 10°C/min. According to the same document, it is described that a cured product made of this epoxy resin composition has excellent Tg property, weight retention at high temperature for a long period of time, and mechanical strength retention, and the epoxy resin composition has excellent fluidity.

### RELATED DOCUMENT

### PATENT DOCUMENT

[Patent Document 1] Japanese Unexamined Patent Publication No. 2001-106771
[Patent Document 2] International Publication No. 2014/065152

### SUMMARY OF THE INVENTION

### TECHNICAL PROBLEM

However, in the related arts described in Patent Documents 1 and 2, regarding the heat treatment in an injection molding extruder, curing was carried out from a kneading region to a nozzle region in injection molding, and as a result, kneading defects occurred, clogging sprue of a mold occurred, or the like.

Therefore, an object of the present invention is to provide an encapsulating resin composition for injection molding, which is stable against heat treatment in an injection molding extruder and can shorten a molding cycle since the above-mentioned problems do not occur.

### SOLUTION TO PROBLEM

The present inventors have found that the problems can be solved by having width in a half value of a maximum exothermic peak within a predetermined range in a DSC curve obtained by using a differential scanning calorimeter and have completed the present invention.

That is, the present invention can be shown as follows.

According to the present invention,
provided is an encapsulating resin composition for injection molding including (A) a thermosetting resin, (B) a curing agent, (C) an inorganic filler, and (D) a curing accelerator,
in which in a DSC curve obtained in a case where a temperature is raised from 30°C to 330°C by using a differential scanning calorimeter under a condition of a temperature rise rate of 10°C/min,
a peak temperature of a maximum exothermic peak is equal to or higher than 155°C and lower than 175°C, and
width in a half value of the maximum exothermic peak, which is obtained by adopting a straight baseline that connects a point of a minimum heat flow before the maximum exothermic peak and a point of a minimum heat flow after the maximum exothermic peak, is equal to or lower than 32°C.

According to the present invention,
provided is a structure including a cured product of the encapsulating resin composition for injection molding.

### ADVANTAGEOUS EFFECTS OF INVENTION

Since the encapsulating resin composition for injection molding of the present invention is excellent in thermal stability and curability in a well-balanced manner, it is possible to suitably use the encapsulating resin composition for injection molding, which is stable against heat treatment in the injection molding extruder and can shorten the molding cycle.

### BRIEF DESCRIPTION OF THE DRAWINGS

Fig. 1 is a schematic cross-sectional view showing an example of an in-vehicle electronic control unit according to an embodiment.
Fig. 2 is a DSC curve obtained by DSC measurement with respect to an encapsulating resin composition for injection molding of Example 1.

### DESCRIPTION OF EMBODIMENTS

Hereinafter, an embodiment of the present invention will be described with reference to the drawings. In all drawings, components identical to those of the above embodiment are denoted by the same reference numerals, and description thereof will not be repeated as appropriate. In addition, "to" represents "equal to or more than" to "equal to or less than", unless otherwise specified.

An encapsulating resin composition for injection molding of the present embodiment contains a thermosetting resin (A), a curing agent (B), an inorganic filler (C), and a curing accelerator (D).

In a DSC curve obtained in a case where a temperature is raised from 30°C to 330°C by using a differential scanning calorimeter under a condition of a temperature rise rate of 10°C/min,
a peak temperature of a maximum exothermic peak is equal to or higher than 155°C and lower than 175°C, preferably equal to or higher than 155°C and equal to or lower than 170°C, and even more preferably equal to or higher than 155°C and equal to or lower than 168°C,
width in a half value of the maximum exothermic peak, which is obtained by adopting a straight baseline that connects a point of a minimum heat flow before the maximum exothermic peak and a point of a minimum heat flow after the maximum exothermic peak, is equal to or lower than 32°C and preferably equal to or lower than 30°C, and a lower limit value is not particularly limited, but is equal to or higher than 20°C.

The present inventors have paid attention to a maximum exothermic peak temperature in the DSC curve of the encapsulating resin composition and have found that by using the width in the half value as an index, thermal stability and curability in a molding step of the encapsulating resin composition, and the balance between the thermal stability and curability can be evaluated. The present inventors have conducted diligent research based on these findings and have found that since the balance between the thermal stability and curability is excellent by the width in the half value of the maximum exothermic peak temperature being equal to or less than the predetermined value, it is possible to control curing from a kneading region in injection molding to a nozzle region and suppress kneading defects of an occurrence of clogging the sprue of a mold, and as a result, heat treatment in the injection molding extruder of the encapsulating resin composition is stable, and a molding cycle is improved, thereby the present inventors having completed the present invention.

Furthermore, from the viewpoint of an effect of the present invention, in the encapsulating resin composition for injection molding of the present embodiment,
in a case where a torque value is measured over time under conditions of a rotation speed of 30 rpm and a measurement temperature of 130°C by using a Labo Plastomill, a time T1 at which the torque value is equal to or less than twice a minimum torque value a is equal to or more than 65 seconds and equal to or less than 200 seconds, preferably equal to or more than 90 seconds and equal to or less than 180 seconds, and even more preferably equal to or more than 110 seconds and equal to or less than 170 seconds, and
in a case where a torque value is measured over time under conditions of a rotation speed of 30 rpm and a measurement temperature of 150°C, a time T1' at which the torque value is equal to or less than twice a minimum torque value b is equal to or more than 35 seconds and equal to or less than 150 seconds, preferably equal to or more than 40 seconds and equal to or less than 120 seconds, and even more preferably equal to or more than 45 seconds and equal to or less than 100 seconds.

By controlling behavior of torque change measured with a Labo Plastomill under the specific conditions, it is possible to further improve the balance between storability and fillability at room temperature, and the curability and connection reliability.

In the present embodiment, from the viewpoint of the effect of the present invention, the minimum torque value a is equal to or more than 0.5 N·m and equal to or less than 10 N·m, preferably equal to or more than 0.8 N·m and equal to or less than 5.0 N·m, and even more preferably equal to or more than 1.0 N·m and equal to or less than 2.8 N·m, and
the minimum torque value b is equal to or more than 0.1 N·m and equal to or less than 4 N·m, preferably equal to or more than 0.2 N·m and equal to or less than 2.5 N·m, and even more preferably equal to or more than 0.5 N·m and equal to or less than 2 N·m.

In this way, by controlling curing characteristics measured with the Labo Plastomill, an encapsulating resin composition for injection molding in which the fillability is excellent, the generation of an unfilled part is suppressed, and the molding cycle is improved, that is, a resin molding material excellent in moldability can be achieved.

A time to reach T₁₀ and a time to reach T₉₀, which are measured based on the peak temperature of the maximum exothermic peak and the width in the half value of the maximum exothermic peak in the DSC curve, and furthermore, measured with the curelastometer, can be controlled by, for example, appropriately adjusting each of kinds and contents of individual components contained in the encapsulating resin composition for injection molding, a particle size distribution of the resin molding material, and the like. In the present embodiment, for example, kinds and contents of the thermosetting resin, the curing agent, the inorganic filler, the imidazole-based catalyst, and the like may be adjusted.

Furthermore, the peak temperature of the maximum exothermic peak in the DSC curve can be shifted to a low temperature side by adjusting kneading conditions (temperature and time) of the encapsulating resin composition for injection molding.

The composition of the encapsulating resin composition for injection molding of the present embodiment will be described.

### [Thermosetting Resin (A)]

The thermosetting resin (A) contains one or two or more kinds selected from the group consisting of, for example, an epoxy resin, a phenol resin, an oxetane resin, a (meth)acrylate resin, an unsaturated polyester resin, a diallyl phthalate resin, and a maleimide resin. Among these, from the viewpoint of improving curability, storage stability, heat resistance, moisture resistance, and chemical resistance, it is particularly preferable to contain an epoxy resin.

As the epoxy resin contained in the thermosetting resin (A), a monomer, an oligomer, or a polymer, which has two or more epoxy groups in one molecule, can be used in general, and a molecular weight and a molecular structure thereof are not particularly limited. The epoxy resin in the present embodiment contains one or two or more kinds selected from the group consisting of biphenyl-type epoxy resins; bisphenol-type epoxy resins such as a bisphenol A-type epoxy resin, a bisphenol F-type epoxy resin, and a tetramethylbisphenol F-type epoxy resin; stilbene-type epoxy resins; novolac-type epoxy resins such as a phenol novolac-type epoxy resin and an orthocresol novolac-type epoxy resin; polyfunctional epoxy resins such as a trisphenol-type epoxy resin exemplified by a triphenol methane-type epoxy resin and an alkyl modified triphenol methane-type epoxy resin; phenolaralkyl-type epoxy resins such as a phenolaralkyl-type epoxy resin having a phenylene skeleton, a naphtholaralkyl-type epoxy resin having a phenylene skeleton, a phenolaralkyl-type epoxy resin having a biphenylene skeleton, and a naphtholaralkyl-type epoxy resin having a biphenylene skeleton; naphthol-type epoxy resins such as a dihydroxynaphthalene-type epoxy resin and an epoxy resin obtained by glycidyl-etherification of a dimer of dihydroxynaphthalene; triazine nucleus-containing epoxy resins such as triglycidyl isocyanurate and monoallyl diglycidyl isocyanurate; bridged cyclic hydrocarbon compound-modified phenol-type epoxy resins such as a dicyclopentadiene-modified phenol-type epoxy resin, and the like.

Among these, from the viewpoint of the effect of the present invention, it is preferable to contain one or two or more kinds selected from an orthocresol novolac-type epoxy resin, a phenol novolac-type epoxy resin, and a bisphenol A-type epoxy resin.

It is also preferable that the epoxy resin contains a polyfunctional epoxy resin having three or more epoxy groups in a repeating structure of the epoxy resin skeleton. By using the polyfunctional epoxy resin, the glass transition temperature of the cured product can be improved.

The polyfunctional epoxy resin is not particularly limited, but examples thereof include a tetraphenylethane-type epoxy resin, 2-[4-(2,3-epoxypropoxy)phenyl]-2-[4-[1,1-bis[4-(2,3-epoxypropoxy)phenyl]ethyl]phenyl]propane, tetrakis(glycidyloxyphenyl)ethane, α-2,3-epoxypropoxyphenyl-ω-hydropol(n = 1 to 7){2-(2,3-epoxypropoxy)benziliden-2,3-epoxypropoxyphenylene}, and the like. These may be used alone, or a plurality thereof may be used in combination.

As the polyfunctional epoxy resin, a tetraphenylethane-type epoxy resin is preferable.

In the present embodiment, the thermosetting resin (A) more preferably contains, as an epoxy resin, one or more kinds selected from the group consisting of an orthocresol novolac-type epoxy resin, a phenol novolac-type epoxy resin, a bisphenol A-type epoxy resin, and a tetraphenylethane-type epoxy resin.

The encapsulating resin composition for injection molding of the present embodiment does not contain an epoxy resin represented by the following General Formula (1).

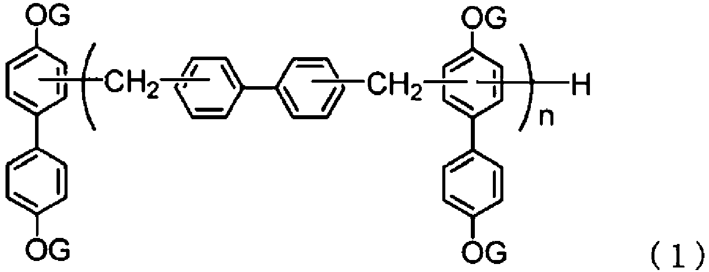

In General Formula (1), n represents 0.2 to 4.0 as an average value, and G represents a glycidyl group.

A content of the thermosetting resin (A) in the encapsulating resin composition for injection molding is preferably equal to or more than 2% by mass, more preferably equal to or more than 3% by mass, and particularly preferably equal to or more than 4% by mass, with respect to the entire encapsulating resin composition for injection molding. By setting the content of the thermosetting resin (A) to equal to or more than the above described lower limit value, the fluidity during the molding can be improved. Therefore, the encapsulating resin composition for injection molding is more excellent in normal temperature storability, and furthermore, it is possible to improve the fillability and the molding stability. By contrast, the content of the thermosetting resin (A) in the encapsulating resin composition for injection molding is preferably equal to or less than 50% by mass, more preferably equal to or less than 30% by mass, and particularly preferably equal to or less than 15% by mass, with respect to the entire encapsulating resin composition for injection molding. By setting the content of the thermosetting resin (A) to equal to or less than the above described upper limit value, it is possible to stabilize the heat treatment in an injection molding extruder and shorten the molding cycle.

The lower limit value and upper limit value of the content of the thermosetting resin (A) in the encapsulating resin composition for injection molding may be optionally combined, but for example, is preferably equal to or more than 2% by mass and equal to or less than 50% by mass, more preferably equal to or more than 3% by mass and equal to or less than 30% by mass, and particularly preferably equal to or more than 4% by mass and equal to or less than 15% by mass.

### [Curing Agent (B)]

The curing agent (B) can be roughly classified into three types, for example, a polyaddition-type curing agent, a catalytic-type curing agent, and a condensation-type curing agent.

Examples of a polyaddition-type curing agent used as the curing agent (B) include one or two or more kinds selected from the group consisting of polyamine compounds containing dicyandiamide (DICY), organic acid dihydrazide, and the like in addition to aliphatic polyamines such as diethylenetriamine (DETA), triethylenetetramine (TETA), and m-xylylenediamine (MXDA), and aromatic polyamines such as diaminodiphenylmethane (DDM), m-phenylenediamine (MPDA), and diaminodiphenylsulfone (DDS); acid anhydrides including alicyclic acid anhydrides such as hexahydrophthalic anhydride (HHPA) and methyltetrahydrophthalic anhydride (MTHPA), aromatic acid anhydrides such as trimellitic anhydride (TMA), pyromellitic anhydride (PMDA), benzophenone tetracarboxylic acid (BTDA), and the like; phenol resin-based curing agents such as a novolac-type phenol resin, polyvinylphenol, and an aralkyl-type phenol resin; polymercaptan compounds such as polysulfide, thioester, and thioether; isocyanate compounds such as an isocyanate prepolymer and a blocked isocyanate; and organic acids such as a carboxylic acid-containing polyester resin.

The catalytic-type curing agent used as the curing agent (B) contains, for example, one or two or more kinds selected from the group consisting of tertiary amine compounds such as benzyldimethylamine (BDMA), 2,4,6-trisdimethylaminomethylphenol (DMP-30); and lewis acids such as BF3 complex.

The condensation-type curing agent used as the curing agent (B) contains, for example, one or two or more kinds selected from the group consisting of a resol-type phenol resin; a urea resin such as a methylol group-containing urea resin; and a melamine resin such as a methylol group-containing melamine resin.

Among these, from the viewpoint of improving the balance between flame resistance, moisture resistance, electrical properties, curability, storage stability, and the like, the curing agent (B) more preferably contains a phenol resin-based curing agent. As the phenol resin-based curing agent, a monomer, an oligomer, or a polymer, which has two or more phenolic hydroxyl groups in one molecule, can be used in general, and a molecular weight and a molecular structure thereof are not particularly limited. The phenol resin-based curing agent used as the curing agent (B) contains, for example, one or two or more kinds selected from the group consisting of novolac-type phenol resins such as phenol novolac resin, cresol novolac resin, and bisphenol novolac; polyvinylphenol; polyfunctional phenol resins such as a triphenol methane-type phenol resin; modified phenol resins such as a terpene-modified phenol resin and a dicyclopentadiene-modified phenol resin; phenolaralkyl-type phenol resins such as a phenolaralkyl resin with a phenylene skeleton and/or a biphenylene skeleton and a naphtholaralkyl resin with a phenylene and/or a biphenylene skeleton; and bisphenol compounds such as bisphenol A and bisphenol F. Among these, from the viewpoint of improving the curability of the encapsulating resin composition for injection molding, it is more preferable to contain at least one of a novolac-type phenol resin or a phenolaralkyl-type phenol resin.

A content of the curing agent (B) in the encapsulating resin composition for injection molding is preferably equal to or more than 1% by mass, more preferably equal to or more than 2% by mass, and particularly preferably equal to or more than 3% by mass, with respect to the entire encapsulating resin composition for injection molding. By setting the content of the curing agent (B) to equal to or more than the above described lower limit value, it is possible to be more excellent in normal temperature storability, achieve excellent fluidity during the molding, and improve the fillability and the moldability. By contrast, the content of the curing agent (B) in the encapsulating resin composition for injection molding is preferably equal to or less than 40% by mass, more preferably equal to or less than 25% by mass, and particularly preferably equal to or less than 10% by mass, with respect to the entire encapsulating resin composition for injection molding. By setting the content of the curing agent (B) to equal to or less than the above described upper limit value, it is possible to stabilize the heat treatment in an injection molding extruder and shorten the molding cycle.

The lower limit value and upper limit value of the content of the curing agent (B) in the encapsulating resin composition for injection molding may be optionally combined, but for example, is preferably equal to or more than 1% by mass and equal to or less than 40% by mass, more preferably equal to or more than 2% by mass and equal to or less than 25% by mass, and particularly preferably equal to or more than 3% by mass and equal to or less than 10% by mass, with respect to the entire encapsulating resin composition for injection molding.

### [Inorganic Filler (C)]

The encapsulating resin composition for injection molding of the present embodiment contains the inorganic filler (C).

The inorganic filler (C) can contain, for example, one or two or more kinds selected from the group consisting of glass fiber, silica such as fused crushed silica and crystalline silica, alumina, aluminum hydroxide, magnesium hydroxide, calcium carbonate, silicon nitride, and aluminum nitride. Among these, from the viewpoint of excellent general versatility, it is preferable to contain glass fiber, fused crushed silica, and calcium carbonate, and more preferable to contain glass fiber and fused crushed silica.

By containing the fused crushed silica in the inorganic filler (C), it is possible to reduce the manufacturing cost of the in-vehicle electronic control unit 10. In a case where the inorganic filler (C) contains crushed silica, a content of the crushed silica can be, for example, equal to or more than 10% by weight and equal to or less than 95% by weight, and is more preferably equal to or more than 15% by weight and equal to or less than 90% by weight, with respect to the entire inorganic filler (C).

In a case where the inorganic filler (C) contains silica, it is preferable to contain silica having an average particle diameter D₅₀ of equal to or more than 1 µm and equal to or less than 50 µm, for example. Thus, it is possible to more effectively improve the balance between fillability, adhesiveness, moisture resistance, heat resistance, and the like. The average particle diameter D50 of silica can be measured using, for example, a commercially available laser particle size distribution meter (for example, SALD-7000 manufactured by Shimadzu Corporation).

A content of the inorganic filler (C) in the encapsulating resin composition for injection molding is preferably equal to or more than 50% by weight, and more preferably equal to or more than 60% by weight, with respect to the entire encapsulating resin composition for injection molding. By setting the content of the inorganic filler (C) to equal to or more than the above described lower limit value, low hygroscopic property and low thermal expansion property are improved, so that the moisture resistance reliability and reflow resistance of the in-vehicle electronic control unit can be more effectively improved. By contrast, the content of the inorganic filler (C) in the encapsulating resin composition for injection molding is preferably equal to or less than 90% by weight, and more preferably equal to or less than 85% by weight, with respect to the entire encapsulating resin composition for injection molding. By setting the content of the inorganic filler (C) to equal to or less than the above described upper limit value, it is possible to more effectively improve the fluidity and the fillability during the molding of the encapsulating resin composition for injection molding.

The lower limit value and upper limit value of the content of the inorganic filler (C) in the encapsulating resin composition for injection molding may be optionally combined, but for example, is preferably equal to or more than 50% by mass and equal to or less than 90% by mass, and more preferably equal to or more than 60% by mass and equal to or less than 85% by mass, with respect to the entire encapsulating resin composition for injection molding.

### [Curing Accelerator (D)]

The encapsulating resin composition for injection molding of the present embodiment contains the curing accelerator (curing catalyst) (D). The curing accelerator (D) may be any known one as long as the curing accelerator promotes a crosslinking reaction between the thermosetting resin (A) and the curing agent (B).

Examples of the curing accelerator (D) include imidazole catalysts such as imidazole, 2-undecylimidazole, 2-heptadecylimidazole, 1,2-dimethylimidazole, 2-ethyl-4-methylimidazole (EMI24), 2-phenylimidazole, 2-phenyl-4-methylimidazole (2P4MZ), 1-benzyl-2-phenylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl(1')]-ethyl-s-triazine, 2,4-diamino-6-[2'-undecylimidazolyl(1')]-ethyl-s-triazine, 2,4-diamino-6-[2'-ethyl-4-methylimidazolyl(1')]-ethyl-s-triazine, an isocyanuric acid adduct of 2,4-diamino-6-[2'-methylimidazolyl(1')]-ethyl-s-triazine, an isocyanuric acid adduct of 2-phenylimidazole, an isocyanuric acid adduct of 2-methylimidazole, 2-phenyl-4,5-dihydroxydimethylimidazole, 2-phenyl-4-methyl-5-hydroxymethylimidazole, 2-phenyl-4,5-dihydroxymethylimidazole, and 2,4-diamino-6-[2-(2-methyl-1-imidazolyl)ethyl]-1,3,5-triazine;
urea-based catalysts such as 1,1'-(4-methyl-m-phenylene)bis(3,3-dimethylurea) and N, N'-dimethylurea; and the like. These may be used alone or may be used in combination of two or more kinds thereof.

Among these, from the viewpoint of improving the low-temperature curability and the fillability, it is preferable to contain one or more kinds selected from the group consisting of 2-phenyl-4,5-dihydroxymethylimidazole, 1,1'-(4-methyl-m-phenylene)bis(3,3-dimethylurea), and N, N'-dimethylurea.

In addition, from the viewpoint of the balance between the low-temperature curability and the fillability, the number of functional groups of the curing accelerator (D) is preferably equal to or less than 3 and more preferably equal to or less than 2.

The encapsulating resin composition for injection molding of the present embodiment does not contain dimethylurea-based curing accelerators represented by the following Chemical Formulae (1) to (3).

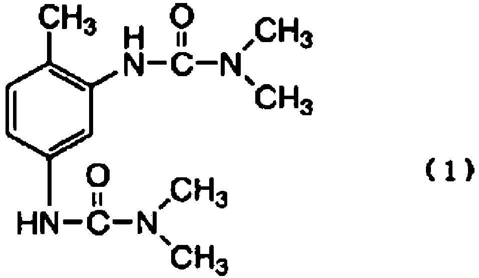

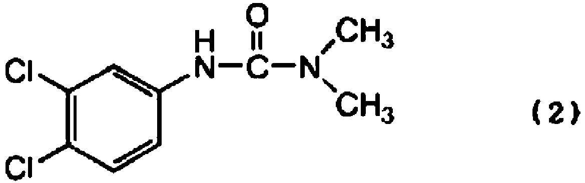

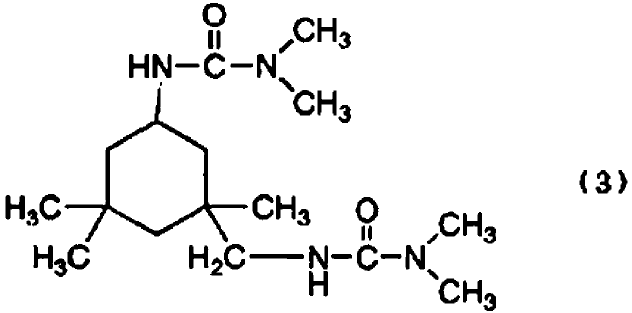

In the present embodiment, the lower limit value of a content of the curing accelerator (D) is preferably, for example, equal to or more than 0.1% by mass, more preferably equal to or more than 0.2% by mass, and particularly preferably equal to or more than 0.3% by mass, with respect to the total solid content of the encapsulating resin composition for injection molding. By setting the content of the curing accelerator to equal to or more than the above described lower limit value, the curability during the molding can be effectively improved. By contrast, the upper limit value of the content of the curing accelerator (D) is preferably, for example, equal to or less than 3.0% by mass, more preferably equal to or less than 2.0% by mass, and particularly preferably equal to or less than 1.5% by mass, with respect to the total solid content of the encapsulating resin composition for injection molding. By setting the content of the curing accelerator to equal to or less than the above described upper limit value, the fluidity during the molding can be improved.

The lower limit value and upper limit value of the content of the curing accelerator (D) in the encapsulating resin composition for injection molding may be optionally combined, but for example, is preferably equal to or more than 0.1% by mass and equal to or less than 3.0% by mass, more preferably equal to or more than 0.2% by mass and equal to or less than 2.0% by mass, and particularly preferably equal to or more than 0.3% by mass and equal to or less than 1.5% by mass, with respect to the total solid content of the encapsulating resin composition for injection molding.

In addition, the lower limit value of the content of the curing accelerator (D) is preferably, for example, equal to or more than 3.5% by mass, more preferably equal to or more than 4.0% by mass, and particularly preferably equal to or more than 5.0% by mass, with respect to the total solid content of the epoxy resin. By setting the content of the curing accelerator (D) to equal to or more than the above described lower limit value, the low-temperature curability during the molding can be effectively improved. By contrast, the upper limit value of the content of the curing accelerator (D) is preferably, for example, equal to or less than 12.0% by mass, more preferably equal to or less than 11.0% by mass, and particularly preferably equal to or less than 10.0% by mass, with respect to the total solid content of the epoxy resin. By setting the content of the curing accelerator (D) to equal to or less than the above described upper limit value, the fluidity during the molding can be improved.

The lower limit value and upper limit value of the content of the curing accelerator (D) in the encapsulating resin composition for injection molding may be optionally combined, but for example, is preferably equal to or more than 3.5% by mass and equal to or less than 12.0% by mass, more preferably equal to or more than 4.0% by mass and equal to or less than 11.0% by mass, and particularly preferably equal to or more than 5.0% by mass and equal to or less than 10.0% by mass, with respect to the total solid content of the epoxy resin.

### (Other Components)

The encapsulating resin composition for injection molding of the present embodiment can be appropriately blended, as necessary, with one or more kinds of various additives such as a releasing property imparting agent, a coloring agent, an ion scavenger, oil, a low stress agent, and a flame retarder.

Examples of the releasing property imparting agent can include one or two or more kinds selected from natural wax such as carnauba wax, synthetic wax such as montanoic acid ester wax or polyethylene oxide wax, a higher aliphatic acid such as zinc stearate and metal salts thereof, and paraffin. Examples of the coloring agent can include any one or both carbon black and black titanium oxide.

Examples of the ion scavenger can include hydrotalcite. Examples of the oil can include silicone oil. Examples of the low stress agent can include silicone rubber. Examples of the flame retarder can include one or two or more kinds selected from magnesium hydroxide, zinc borate, zinc molybdate, and phosphazene.

Examples of the antioxidant can include one or two or more kinds selected from the group consisting of an aromatic amine-based antioxidant, a hindered phenol-based antioxidant, a hindered amine-based antioxidant, a sulfur-containing antioxidant, and a phosphorus-containing antioxidant.

As the hindered phenol-based antioxidant, 3-(4'-hydroxy-3',5'-di-tert-butylphenyl)propionic acid-n-octadecyl can be preferably used.

A content of the antioxidant in the encapsulating resin composition for injection molding is preferably equal to or more than 0.05% by mass and equal to or less than 2.0% by mass and even more preferably equal to or more than 0.1% by mass and equal to or less than 1.0% by mass, with respect to the entire encapsulating resin composition for injection molding (100% by mass). By setting the content of the antioxidant within the above described range, deterioration of the encapsulating resin composition for injection molding can be suppressed during the molding of the encapsulating resin composition for injection molding.

### <Encapsulating Resin Composition for Injection Molding>

The encapsulating resin composition for injection molding of the present embodiment can be obtained by mixing the above described components by a known method in the related art. Since the cured product (encapsulating material) obtained by heating and curing the encapsulating resin composition for injection molding of the present embodiment has the above described composition, the cured product has excellent mechanical strength, and the generation of cracks in the cured product is suppressed.

Examples of the structure including the cured product of the encapsulating resin composition for injection molding of the present embodiment include an in-vehicle electronic control unit.

### [In-vehicle Electronic Control Unit]

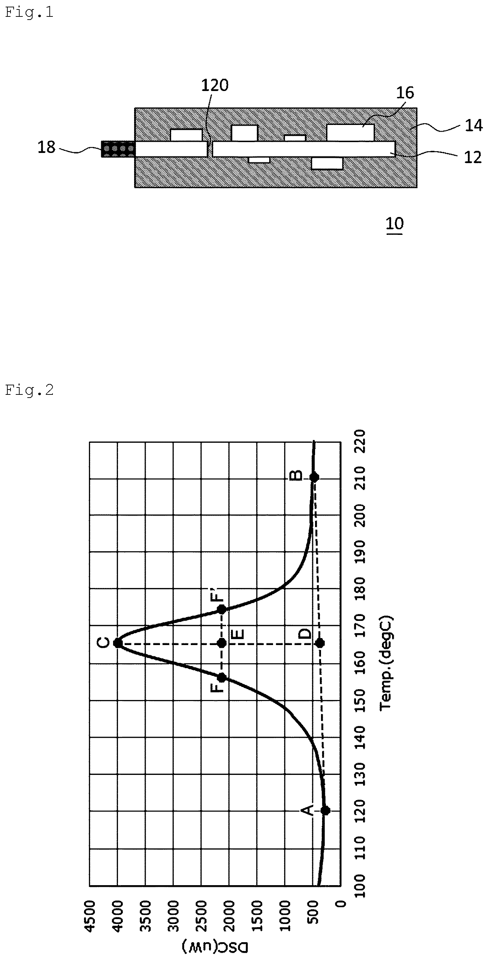

The in-vehicle electronic control unit 10 is used to control an engine, various in-vehicle devices, and the like. As shown in Fig. 1, the in-vehicle electronic control unit 10 includes, for example, a wiring board 12, a plurality of electronic components 16 mounted on at least one surface of the wiring board 12, and an encapsulating resin 14 for encapsulating the electronic components 16. The wiring board 12 is provided with a connection terminal 18 for connecting to the outside at least on one side. The in-vehicle electronic control unit 10 according to an example of the present embodiment is electrically connected to a counterpart connector through the connection terminal 18 by fitting the connection terminal 18 and the counterpart connector.

The wiring board 12 is, for example, a wiring board in which circuit wiring is provided on one side of one surface or the other surface opposite to the one surface, or circuit wirings are provided on both sides. As shown in Fig. 1, the wiring board 12 has, for example, a flat plate shape. In the present embodiment, an organic board formed of, for example, an organic material such as polyimide can be adopted as the wiring board 12. The wiring board 12 may include, for example, a through-hole 120 which penetrates the wiring board 12 and through which one surface is connected to the other surface. In this case, a wiring provided on one surface of the wiring board 12 and a wiring provided on the other surface are electrically connected via a conductor pattern provided in the through-hole 120.

The wiring board 12 includes, for example, a solder resist layer on one surface on which the electronic components 16 are mounted. The solder resist layer can be formed by using a resin composition for forming a solder resist, which is usually used in the field of semiconductor devices. In the present embodiment, for example, a solder resist layer can be provided on one surface and the other surface of the wiring board 12.

The solder resist layer provided on one surface of the wiring board 12 or on both one surface and the other surface is formed of, for example, a resin composition containing a silicone compound. Thus, it is possible to achieve a solder resist layer having excellent surface smoothness.

In manufacturing the in-vehicle electronic control unit 10, it may be difficult to improve the adhesiveness of the encapsulating resin to the wiring board in which a solder resist layer containing a silicone compound or the like is formed on the uppermost layer. In the present embodiment, the encapsulating resin composition for injection molding which contains a thermosetting resin and imidazoles and in which behavior of torque change measured with a Labo Plastomill under specific conditions is controlled is used. Therefore, as described above, even in the case where the solder resist layer containing the silicone compound or the like is provided on the uppermost layer of the wiring board 12, it is possible to improve the balance between the fillability of the encapsulating resin composition for injection molding and the adhesiveness to the wiring board 12 of the encapsulating resin 14.

As shown in Fig. 1, the plurality of electronic components 16 are mounted on, for example, one surface and the other surface of the wiring board 12, respectively. On the other hand, the electronic components 16 may be provided only on one surface of the wiring board 12 and may not be provided on the other surface of the wiring board 12. The electronic components 16 are not particularly limited as long as the electronic components 16 can be mounted on the in-vehicle electronic control unit, and examples thereof include a microcomputer.

The encapsulating resin 14 is formed by the molding and curing of the encapsulating resin composition for injection molding to seal the electronic components 16. In the present embodiment, the encapsulating resin 14 is formed to seal the wiring board 12 together with the electronic components 16, for example. In the example shown in Fig. 1, the encapsulating resin 14 is provided to seal one surface and the other surface of the wiring board 12, and the electronic components 16 are mounted on the wiring board 12. The encapsulating resin 14 is formed to seal, for example, a part or the entirety of the wiring board 12. In Fig. 1, a case where the encapsulating resin 14 is provided to seal the entire other portion of the wiring board 12 without encapsulating the connection terminal 18 so that the connection terminal 18 is exposed.

In the in-vehicle electronic control unit 10 according to the present embodiment, the wiring board 12 may be mounted on, for example, a metal base. The metal base can function as, for example, a heat sink for dissipating heat generated from the electronic components 16. In the present embodiment, for example, a metal base and the wiring board 12 mounted on the metal base can be integrally sealed and molded by the encapsulating resin composition for injection molding to form the in-vehicle electronic control unit 10. A metal material constituting the metal base is not particularly limited, and examples thereof may include iron, copper, aluminum, and alloys containing one or more of these. The in-vehicle electronic control unit 10 may not include the metal base.

The in-vehicle electronic control unit 10 exemplified in Fig. 1 is obtained by encapsulating and molding the plurality of electronic components 16 with the encapsulating resin composition for injection molding by injection molding.

Specifically, first, the wiring board 12 on which the plurality of electronic components 16 are mounted is disposed in a cavity of a mold. Then, the encapsulating resin composition for injection molding of the present embodiment is charged into, via a hopper, an extruder (cylinder) having a screw therein, and the encapsulating resin composition for injection molding is melted at an extruder temperature of equal to or higher than 80°C and 100°C. The molten resin is moved in the extruder with the screw and injection-charged into the cavity of the mold through a gate to seal the plurality of electronic components 16.

In the encapsulating resin composition for injection molding of the present embodiment, the maximum exothermic peak temperature in the DSC curve is within the predetermined range, and furthermore, the width in the half value of the maximum exothermic peak is within the predetermined range. Therefore, the temperature during the heat treatment is stable in the extruder, and the molding cycle is shortened.

Although the embodiment of the present invention is described above, the embodiment is an example of the present invention, and various configurations other than the above embodiment can be adopted as long as the effects of the present invention are not impaired.

### [Examples]

Hereinafter, the present invention will be described in more detail with examples, but the present invention is not limited thereto.

### [Examples 1 to 5 and Comparative Examples 1 to 8]

For each of Examples 1 to 5 and Comparative Examples 1 to 8, encapsulating resin compositions for injection molding were prepared as follows.

First, according to formulations shown in Table 1, each component was premixed for 20 minutes with a Henschel mixer (capacity of 200 liters, rotation speed of 900 rpm) set in a room temperature state. Next, the obtained mixture was finely pulverized while keeping a material temperature at equal to or lower than 30°C with a material supply amount of 200 kg/hr, by using a continuous rotary ball mill (dynamic mill MYD25 manufactured by NIPPON COKE AND ENGINEERING. CO., LTD., screw rotation speed of 500 rpm, alumina ball diameter of 10 mm, ball volume filling ratio of 50% with respect to device volume). The finely pulverized mixture was then kneaded using two rolls of 10 inches. The roll temperature was set to 105°C and 15°C, and kneaded. A kneading time was set to 5 minutes. A kneading time of Example 4 was set to 20 minutes, and a kneading time of Example 5 was set to 40 minutes. Then, the mixture after kneading was cooled and pulverized to obtain an encapsulating resin composition for injection molding. Each step from premixing with a Henschel mixer to obtaining the encapsulating resin composition for injection molding was continuously performed. The details of each component in Table 1 are as follows. In addition, the unit in Table 1 is % by weight.

### (A) Thermosetting Resin

- Epoxy resin 1: Orthocresol novolac-type epoxy resin (EPICLON N-670, manufactured by DIC Corporation)
- Epoxy resin 2: Tetraphenylethane-type epoxy resin (JER 1031S, manufactured by Mitsubishi Chemical Corporation)

### (B) Curing Agent

- Phenol resin 1: Novolac-type phenol resin (PR-53195, manufactured by Sumitomo Bakelite Co., Ltd., hydroxyl group equivalent: 104 g/eq)

### (C) Inorganic Filler

- Glass fiber: CS3E479, manufactured by Nitto Boseki Co., Ltd.
- Silica 1: Crushed silica (RD-8, manufactured by TATSUMORI LTD., average particle diameter D₅₀ = 15 µm)
- Silica 2: Crushed silica (F-207, manufactured by FUMITECH Co., Ltd., average particle diameter D₅₀ = 7 µm)

### (D) Curing Catalyst

- Curing catalyst 1: 2-Phenyl-4,5-dihydroxymethylimidazole represented by the following Chemical Formula (melting point: 225°C to 235°C, molecular weight: 204, active temperature range:155°C to 175°C, (2PHZ-PW, manufactured by Shikoku Chemicals Corporation, fine powder))
   In this example, the active temperature range was measured by the method described above. 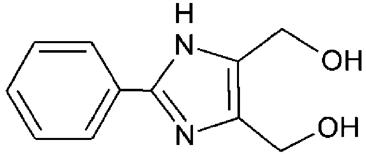
- Curing catalyst 2: 2-Phenyl-4-methylimidazole represented by the following Chemical Formula (melting point: 174°C to 184°C, molecular weight: 172, active temperature range: 110°C to 125°C (2P4MZ, manufactured by Shikoku Chemicals Corporation)) 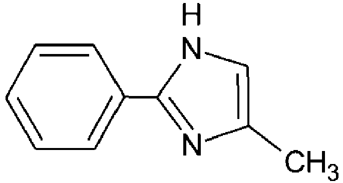
- Curing catalyst 3: 2-Phenylimidazole represented by the following Chemical Formula (melting point: 137°C to 147°C, molecular weight: 144, active temperature range: 105°C to 125°C (2PZ, manufactured by Shikoku Chemicals Corporation)) 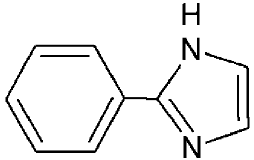
- Curing catalyst 4: N,N'-Dimethylurea (manufactured by Tokyo Chemical Industry)
- Curing catalyst 5: 1,1'-(4-methyl-m-phenylene)bis(3,3-dimethylurea) represented by the following Chemical Formula (AMICURE UR2T, manufactured by Evonik Industries AG)

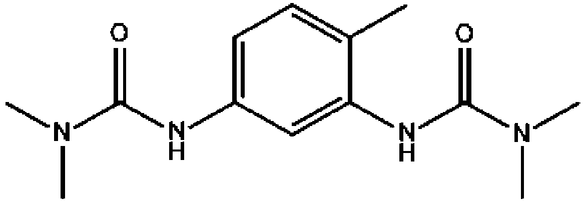

### (E) Other Components

- Low stress agent: Silicone rubber (CF2152, manufactured by Dow Corning Toray Co., Ltd.)
- Releasing property imparting agent: Calcium stearate (manufactured by Tokyo Chemical Industry)
- Coloring agent: Carbon black (#5, manufactured by Mitsubishi Chemical Corporation)

### (DSC Measurement)

The encapsulating resin composition for injection molding obtained in each of Examples and each of Comparative Examples was finely pulverized in a mortar, and 3 to 5 mg was weighed into an aluminum pan to prepare a sample. Then, the sample was subjected to differential scanning calorimetry by using a differential scanning calorimeter (DSC7020, Hitachi High-Tech Science Corporation) under conditions of a starting temperature of 30°C, a measurement temperature range of 30°C to 330°C, and a temperature rise rate of 10°C/min. Based on the obtained DSC curve, a peak temperature (°C) of a maximum exothermic peak, width (°C) in a half value of the maximum exothermic peak, a minimum temperature (°C) before the maximum exothermic peak, and a minimum temperature (°C) after the maximum exothermic peak were calculated.

Fig. 2 shows a DSC curve obtained by DSC measurement on the encapsulating resin composition for injection molding obtained in Example 1. Hereinafter, a method of calculating width (°C) in a half value of a maximum exothermic peak in each of Examples and each of Comparative Examples will be described using Example 1 as an example.

The width (°C) in the half value of the maximum exothermic peak was calculated as follows. First, a straight line that connects a point A of a minimum heat flow before the maximum exothermic peak (minimum temperature before maximum exothermic peak) and a point B of a minimum heat flow after the maximum exothermic peak (minimum temperature after maximum exothermic peak) was defined as a baseline. Next, an intersection point of a perpendicular line of an X-axis passing through a point C where a heat flow of the exothermic peak was maximum and the baseline was defined as a point D. Next, in a case where a straight line was drawn to pass through a point E that was the midpoint of a straight line CD and to be parallel to the X axis, points intersecting with the DSC curve were defined as points F and F', respectively. Then, the length of a straight line FF' was defined as "width in a half value of the maximum exothermic peak".

(Measurement of Times T1 and T1', and minimum torque values a and b in a Labo Plastomill tester)

For each of Examples and each of Comparative Examples, times T1 and T1' and minimum torque values of the obtained encapsulating resin composition for injection molding were measured as follows. First, melting torque of the encapsulating resin composition for injection molding was measured over time by using a Labo Plastomill tester (4C150 manufactured by Toyo Seiki Seisaku-sho, Ltd.) under conditions of a rotation speed of 30 rpm and a measurement temperature of 130°C. Next, a time T1 in which a torque value was equal to or less than twice a minimum torque value was calculated based on the measurement result. The measurement start point was a point where a material was charged into the Labo Plastomill tester, the torque suddenly increased, and then the torque was started to decrease. The minimum torque value a was calculated based on the measurement result.

Similarly, melting torque of the encapsulating resin composition for injection molding was measured over time under conditions of a rotation speed of 30 rpm and a measurement temperature of 150°C, and the time T1 in which a torque value was equal to or less than twice a minimum torque value and the minimum torque value b were calculated based on the measurement result. The results are shown in Table 1. The units of the times T1 and T1' in Table 1 are seconds, and the units of the minimum torque values a and b are N·m.

### (Glass Transition Temperature (Tg))

A bending test piece of JIS6911 was molded at 175°C for 3 minutes, TMA measurement in a flow direction was performed, and a bending point was defined as Tg. The temperature rise 5°C/min was carried out. It is considered that the higher the Tg after the molding (without curing), the shorter the molding cycle.

### (Thermal Stability Test)

A dumbbell test piece (test piece) of ISO178 was molded by using a 100t electric injection molding machine (product number; EC-100SXR, manufactured by Toshiba Machine Co., Ltd.). A mold temperature of the 100t electric injection molding machine was set to 165°C, and a nozzle temperature was set to 85°C/65°C/45°C. An injection time was set to 15 seconds, and a curing time was set to 100 seconds. The injection speed was set to 5 mm/sec, and a holding pressure was set to 30 MPa for 5 seconds. Injection molding was carried out with an injection waiting time after weighing set to 0 minutes or 5 minutes, and a total weight of the obtained test pieces (2 ISO test pieces + sprue + runner) was measured. A weight in a case where injection molding was carried out with a waiting time of 0 minutes was denoted by W0, a weight in a case where injection molding was carried out with a waiting time of 5 minutes was denoted by W5, (W5/W0) × 100 of equal to or more than 98% was denoted by o, and (W5/W0) × 100 of less than 98% was denoted by x.

[Table 1]

**Table 1**

| | | | Example 1 | Example 2 | Example 3 | Example 4 | Example 5 | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|---|---|---|---|
| Thermosetting resin A | Epoxy resin 1 | % by mass | 13.8 | 13.8 | | 13.8 | 13.8 | 13.8 | 13.8 | | 13.8 | | 13.8 | 13.8 | 13.8 |
| | Epoxy resin 2 | | | | 13.8 | | | | | 13.8 | | 13.8 | | | |
| Curing agent B | Phenol resin 1 | | 6.1 | 6.1 | 6.1 | 6.1 | 6.1 | 6.1 | 6.1 | 6.1 | 6.1 | 6.1 | 6.1 | 6.1 | 6.1 |
| Inorganic filler C | Glass fiber | | 15 | 15 | 15 | 15 | 15 | 15 | 15 | 15 | 15 | 15 | 15 | 15 | 15 |
| | Silica 1 | | 27.4 | 27.4 | 26.8 | 27.4 | 27.4 | 27.7 | 27.85 | 27.4 | 27.85 | 27.4 | 27.4 | 27.85 | 27.85 |
| | Silica 2 | | 35 | 35 | 35 | 35 | 35 | 35 | 35 | 35 | 35 | 35 | 35 | 35 | 35 |
| Curing accelerator D | Curing catalyst 1 | | 0.6 | | | 0.6 | 0.6 | 0.3 | 0.15 | 0.6 | | | | | |
| | Curing catalyst 2 | | | | | | | | | | | | | | 0.15 |
| | Curing catalyst 3 | | | | | | | | | | | | | 0.15 | |
| | Curing catalyst 4 | | | | 1.2 | | | | | | | 0.6 | 0.6 | | |
| | Curing catalyst 5 | | | 0.6 | | | | | | | 0.15 | | | | |
| Low stress agent | Silicone rubber | | 1.2 | 1.2 | 1.2 | 1.2 | 1.2 | 1.2 | 1.2 | 1.2 | 1.2 | 1.2 | 1.2 | 1.2 | 1.2 |
| Releasing property imparting agent | Calcium stearate | | 0.6 | 0.6 | 0.6 | 0.6 | 0.6 | 0.6 | 0.6 | 0.6 | 0.6 | 0.6 | 0.6 | 0.6 | 0.6 |
| Coloring agent | Carbon black #5 | | 0.3 | 0.3 | 0.3 | 0.3 | 0.3 | 0.3 | 0.3 | 0.3 | 0.3 | 0.3 | 0.3 | 0.3 | 0.3 |
| Total | | % by mass | 100 | 100 | 100 | 100 | 100 | 100 | 100 | 100 | 100 | 100 | 100 | 100 | 100 |
| Kneading temperature | Front roll temperature (rear of 15°C) | °C | 105 | 105 | 105 | 105 | 105 | 105 | 105 | 105 | 105 | 105 | 105 | 105 | 105 |
| | Kneading time | Minute | 5 | 5 | 5 | 20 | 40 | 5 | 5 | 5 | 5 | 5 | 5 | 5 | 5 |
| DSC | Peak temperature | °C | 166 | 160 | 156 | 165 | 161 | 172 | 176 | 148 | 170 | 163 | 175 | 158 | 157 |
| | Width of half value | °C | 29.5 | 27.0 | 29.5 | 30.0 | 31.0 | 34.5 | 38.0 | 29.5 | 33.0 | 33.5 | 36.0 | 34.5 | 35.0 |
| | Minimum value before peak temperature | °C | 131 | 131 | 119 | 130 | 128 | 128 | 128 | 114 | 131 | 128 | 136 | 120 | 121 |
| | Minimum value after peak temperature | °C | 190 | 185 | 178 | 190 | 190 | 197 | 204 | 173 | 197 | 195 | 208 | 189 | 191 |
| Torque measured by Labo Plastomill | Minimum torque at 130°C | N·m | 2.34 | 3.6 | 8 | 2.66 | 2.34 | 2.01 | 2.07 | 8.9 | 2.8 | 4.5 | 1.66 | 3.4 | 3.3 |
| | T1 (time of equal to or less than twice minimum torque) | Second | 174 | 125 | 69 | 158 | 174 | 210 | 290 | 55 | 215 | 170 | 250 | 78 | 79 |
| | Minimum torque at 150°C (N·m) | N·m | 1.1 | 1.5 | 4 | 1.8 | 1.1 | 0.9 | 0.85 | 4.8 | 1.1 | 2.2 | 0.75 | 1.8 | 1.9 |
| | T1' (time of equal to or less than twice minimum torque) | Second | 53 | 45 | 35 | 48 | 53 | 73 | 130 | 23 | 90 | 45 | 135 | 34 | 35.3 |
| Tg by TMA | | °C | 175 | 150 | 170 | 178 | 180 | 140 | 115 | 195 | 105 | 142 | 105 | 132 | 136 |
| Thermal stability test | W0 | g | 59.5 | 59.5 | 59.5 | 59.5 | 59.5 | 59.5 | 59.5 | 59 | 59.5 | 59.5 | 59.5 | 59.4 | 59.6 |
| | W5 | g | 59.5 | 59.2 | 58.5 | 59.4 | 59.4 | 59.5 | 59.5 | 47 | 59.5 | 59.5 | 59.5 | 59 | 59 |
| | W5/W0 *100 | % | 100 | 99.4958 | 98.3193 | 99.8319 | 99.8319 | 100 | 100 | 79.661 | 100 | 100 | 100 | 99.3266 | 98.9933 |
| | Determination | | ○ | ○ | ○ | ○ | ○ | ○ | ○ | × | ○ | ○ | ○ | ○ | ○ |

As shown in Table 1, in the DSC curve obtained in a case where a temperature is raised from 30°C to 330°C by using a differential scanning calorimeter under a condition of a temperature rise rate of 10°C/min, according to the encapsulating resin composition for injection molding of Example in which the peak temperature of a maximum exothermic peak was equal to or higher than 155°C and lower than 175°C, and the width in the half value of the maximum exothermic peak was equal to or lower than 65°C, the thermal stability was excellent, Tg was high, the curability was excellent, and the balance between these properties was excellent. Therefore, it was clarified that the encapsulating resin composition for injection molding of Example could be stable with respect to the heat treatment in the injection molding extruder and suitably used in injection molding in which the molding cycle was shortened.

The present application claims priority on the basis of Japanese Patent Application No. 2021-023120 filed on February 17, 2021, the disclosure of which is incorporated herein in its entirety by reference.

### REFERENCE SIGNS LIST

- 10:: In-vehicle electronic control unit
- 12:: Wiring board
- 14:: Encapsulating resin
- 16:: Electronic component
- 18:: Connection terminal
- 120:: Through-hole

## Claims

1. An encapsulating resin composition for injection molding, comprising:
(A) a thermosetting resin;
(B) a curing agent;
(C) an inorganic filler; and
(D) a curing accelerator,
wherein in a DSC curve obtained in a case where a temperature is raised from 30°C to 330°C by using a differential scanning calorimeter under a condition of a temperature rise rate of 10°C/min,
a peak temperature of a maximum exothermic peak is equal to or higher than 155°C and lower than 175°C, and
width in a half value of the maximum exothermic peak, which is obtained by adopting a straight baseline that connects a point of a minimum heat flow before the maximum exothermic peak and a point of a minimum heat flow after the maximum exothermic peak, is equal to or lower than 32°C.

2. The encapsulating resin composition for injection molding according to claim 1, wherein
in a case where a torque value is measured over time under conditions of a rotation speed of 30 rpm and a measurement temperature of 130°C by using a Labo Plastomill, a time T1 at which the torque value is equal to or less than twice a minimum torque value a is equal to or more than 65 seconds and equal to or less than 200 seconds, and
in a case where a torque value is measured over time under conditions of a rotation speed of 30 rpm and a measurement temperature of 150°C, a time T1' at which the torque value is equal to or less than twice a minimum torque value b is equal to or more than 35 seconds and equal to or less than 150 seconds.

3. The encapsulating resin composition for injection molding according to claim 2, wherein
the minimum torque value a is equal to or more than 0.5 N·m and equal to or less than 10.0 N·m, and
the minimum torque value b is equal to or more than 0.1 N·m and equal to or less than 4.0 N·m.

4. The encapsulating resin composition for injection molding according to any one of claims 1 to 3, wherein the curing accelerator (D) contains one or more kinds selected from the group consisting of 2-phenyl-4,5-dihydroxymethylimidazole, 1,1'-(4-methyl-m-phenylene)bis(3,3-dimethylurea), and N, N'-dimethylurea.

5. The encapsulating resin composition for injection molding according to any one of claims 1 to 4, wherein the thermosetting resin (A) contains, as an epoxy resin, one or more kinds selected from the group consisting of an orthocresol novolac-type epoxy resin, a phenol novolac-type epoxy resin, a bisphenol A-type epoxy resin, and a tetraphenylethane-type epoxy resin.

6. The encapsulating resin composition for injection molding according to any one of claims 1 to 5, wherein the curing agent (B) contains a phenol resin-based curing agent.

7. The encapsulating resin composition for injection molding according to any one of claims 1 to 6, wherein the inorganic filler (C) contains a filler having an average particle diameter D₅₀ of equal to or more than 1 µm and equal to or less than 50 µm.

8. The encapsulating resin composition for injection molding according to any one of claims 1 to 7, wherein the inorganic filler (C) contains fused crushed silica.

9. A structure comprising a cured product of the encapsulating resin composition for injection molding according to any one of claims 1 to 8.
